# EUROPEAN PATENT APPLICATION

(11) **EP 2 423 352 A1**
(43) Date of publication of application: **29.02.2012**
(21) Application number: 10382236.7
(22) Date of filing: 24.08.2010
(51) Int. Cl.: C23C 16/24, C23C 16/46, C01B 33/035

(54) **Thermal shield for silicon production reactors**

(71) Applicant: Centesil S.L., 28040 Madrid (ES)
(72) Inventor: Zamorano Saavedra, Juan Carlos, 28040, Madrid (ES); Del Coso Sánchez, Gonzalo, 28040, Madrid (ES); Dal Cañizo Nadal, Carlos, 28040, Madrid (ES); Luque López, Antonio, 28040, Madrid (ES)
(74) Representative: ABG Patentes, S.L.

(57) **Abstract**

The invention relates to a thermal shield for being used inside a reactor comprising a reaction space wherein there is carried out a silicon growth process by means of chemical vapor deposition or CVD between 1000°C and 1200°C from a flow of precursor gas comprising silicon compounds such as silane or chlorosilanes, circulating through a reaction chamber on an assembly of silicon parts. The thermal shield is manufactured in a material which does not add contaminants to the chemical silicon vapor deposition process and surrounds the assembly of silicon parts such that in operational mode the thermal shield is opaque to infrared radiation.

## Description

### Technical Field of the Invention

The invention is comprised within the field of silicon production processes by means of chemical vapor deposition or CVD within the photovoltaic and microelectronic industry.

### State of the Art

The method of obtaining silicon by means of reducing silicon-derived gaseous compounds (such as silane or chlorosilanes) with hydrogen is widely known and applied in the microelectronic and photovoltaic industry. It consists of introducing said gases, previously purified by distillation, in a reactor where there are thin silicon rods with a high purity (greater than 99.999999%) and having temperatures in the order of 1100°C. The chemical reaction takes place on the surface of said rods due to the high temperatures, high-purity solid silicon being deposited. Processes of this type will be referred to hereinafter as "silicon production processes by chemical vapor deposition or CVD" or "silicon production by CVD". In subsequent processes, the silicon obtained is crystallized and cut into wafers to form part of electronic devices, microelectronic circuits or solar cells. Some reactor diagrams can be observed in the patents with publication numbers GB853789, GB922280, US3042494 and US4179530.

Since the growth of high-purity semiconductor material is involved, it is necessary for the materials forming reactors of this type to not be contaminating, such as quartz, graphite, silicon carbide, or similar elements, as described in the patent with publication number EP0045600. If silver, steel or other metals are used, the parts formed by these materials must be cooled to prevent unwanted chemical reactions inside the reactor which give rise to the contamination of the silicon formed.

The silicon rods need to be heated to approximately 1100°C in order for high-purity silicon to grow on them. This heating is performed by the Joule effect: said rods are electrically connected inside the reactor and electric current is passed through them, their temperature thus being raised. Nevertheless, during the phase of the process in which silicon is deposited, the temperature of the rod decreases due to:
- the heat of the reaction taking place on its surface is endothermic,
- to the radiation emitted by the rod and
- to the cooling to which the inlet gases are subjected.

Generally, although not essentially, the rods have an inverted U shape. Their position is vertical and as straight as possible to prevent breakages at high temperatures due to the loss of rigidity of the rods and the impossibility of supporting their own weight. The initial diameter of the rods is usually at least 4 mm. The rods with which the production process starts are produced in straight sections, a subsequent machining being necessary to give them the characteristic U shape. There is a limitation in the growth of the rod which is imposed by the nature of the heating therein. The center of the rod will be hotter than the surface, on one hand due to the fact that the heat is dissipated with greater difficulty and on the other hand because since it is hotter, it conducts electricity better and more current circulates through said region, which perpetuates the situation. Therefore, the rod cannot continue growing when the temperature in the center reaches the melting point of silicon, about 1410°C. Furthermore, a large difference of temperatures inside the rod causes mechanical stresses capable of breaking it. The maximum growth diameter is in the range of 10-15 cm.

Patent US20030127045 deals with said problems by means of heating the rods with a high-frequency electric current source which, making use of a film effect of the current, allows homogenizing the temperature inside the rod. This allows increasing the growth diameter without the fear of reaching the melting point in the center or excessive mechanical stresses. Nevertheless, this technique introduces problems such as the inductive energy losses and the possibility of the rods breaking due to high-frequency vibrations coinciding with the elastic resonance frequencies of the silicon rods.

The use of thermal shields, i.e., radiation protections minimizing the radiant exchange between the incandescent rods and their environment have also been previously proposed, such as in the patent with publication number GB853729 for example. Said devices, as established in the scientific literature, allow homogenizing the temperature inside the silicon rods and therefore allow increasing the maximum growth diameter. Another beneficial effect of the use of thermal shields (also referred to as radiation shields) is the considerable reduction of the energy radiated by the rods towards their environment. In the aforementioned patent, GB853729, a thermal shield is located outside the reactor vessel. This is possible because in the state of the art, corresponding to the date of publication of said patent, the reactors incorporated vessels with quartz walls, transparent to the radiation, and a single rod therein. The current state of the art, represented by the patents with publication numbers US6395248 and US20020014197, consists of a reactor with between 36 and 48 rods therein, the walls of which are made of steel and are cooled, so this configuration does not allow having the thermal shield outside the reactor. The introduction of thermal shields inside the reactor entails two main technical difficulties due to the high temperatures that they reach: (1) preventing silicon from being deposited on said devices, since said deposition decreases the efficiency of the process, and (2) preventing the materials forming the shields from contaminating the produced silicon in any way.

### Description of the Invention

The object of the invention is to provide a thermal shield suitable for being used in high-purity silicon production reactors.

In a first inventive aspect, a thermal shield defined by independent claim 1 is provided. Said thermal shield is suitable for being arranged inside a reactor for producing high-purity silicon by means of chemical vapor deposition or CVD.

As has been set forth, this production exposes this thermal shield to a chemical reaction of reducing silicon-derived gaseous compounds such as silanes or chlorosilanes with hydrogen. These compounds are comprised in a precursor gas allowing silicon deposition to occur on the surface of the silicon rod or rods. This reaction is carried out in a region of the reactor which is referred to hereinafter as "inner reaction space" and is located inside the reactor. This precursor gas preferably flows into the reactor and is directed towards the inner reaction space for silicon production to occur as a result of the deposition by CVD on at least one silicon rod.

Thus, the thermal shield is formed by a body having a surface partially or completely enveloping an inner reaction space characterized in that at the silicon deposition temperature inside the reactor it is opaque to thermal radiation and non-contaminating.

The configuration of the body of the thermal shield is such that this body at least partially envelops the silicon rods. When openings in the surface are provided in the body of the shield, it has the advantage of being able to be used to allow the establishment of a flow of gas containing the precursors, enabling the circulation on both sides to improve the homogeneity of the chemical reaction.

At least the surface of the thermal shield is made of a non-contaminating material so species are not produced which can be incorporated to the silicon rods during the silicon production process by CVD. This allows producing silicon with a high purity, and particularly with a great purity (greater than 99.999999%) such as that intended for applications in photovoltaic energy generation.

The silicon production is carried out when the temperature of the silicon rod is between 900°C and 1200°C and more preferably at 1100°C. Since a thermal shield opaque to at least infrared radiation and which is located inside the reactor at least partially surrounding said inner reaction space is also provided, thermal energy losses are prevented, maintaining a reaction temperature which does not compromise the quality of the material obtained.

Also, by means of this thermal shield the temperature of the silicon rods is uniformized, which allows increasing the maximum diameter of the rods and therefore increases the productivity of the reactor. Due to the characteristics of the process and of the reactor, this increases allows working in regimes where the energy consumption is more effective. This is due to the fact that when the reaches large rod diameters, greater than 10 cm, the rate of produced silicon increases greatly whereas the power consumed remains almost constant. Since working for a longer time in this regime of large rod diameters is achieved, the mean energy consumed throughout the entire process decreases for the same amount of produced silicon.

This double decrease of the energy costs allows considerably reducing the silicon production cost.

Thus, when a thermal shield is interposed in the path of the radiation towards the exterior, the radiant exchange between the silicon rods and the inner wall of the casing or vessel of the reactor is decreased. The decrease of the energy consumption is such that the energy necessary for maintaining the rods at a deposition temperature of 1100°C can reach about 30% of that used in the same reactor without the presence of the shield.

In a preferred embodiment, at least said surface of the body of the thermal shield is provided coated with a silicon coating. The high-purity silicon is transparent to infrared radiation at room temperature. However, it is possible to find a minimum thickness of 50 µm in which it becomes opaque to infrared radiation above 950°C. In particular, if the silicon coating of the thermal shield has a thickness greater than 50 µm, this layer is opaque to infrared radiation at a temperature of 950°C.

When the thermal shield is preferably manufactured from silicon, there is no chance of contaminating the silicon rods during the production process. Also the silicon accumulated on the surface of the thermal shield does not decrease the efficiency of the production process, since the increase of thickness does not decrease the opacity of the thermal shield. It can be estimated that for temperatures of the thermal shield of about 950°C, around 5% silicon is deposited on the thermal shield.

When the thermal shields are preferably formed only from high-purity silicon, a silicon layer is also obtained as a result of the thermal shield silicon production process. In this case both the silicon deposited on the rods and the silicon deposited on the thermal shield will be considered as produced silicon.

### Description of the Drawings

These and other features and advantages of the invention will be more clearly shown from the following detailed description of a preferred embodiment, given only by way of an illustrative and non-limiting embodiment, with reference to the attached figures.
Figure 1 shows a schematic view of a reactor for producing silicon by CVD as it is found in the state of the art.
Figure 2 depicts a cross-sectional view of a reactor for high-purity silicon deposition.
Figures 3a and 3b depict an elevational view and a cross-section of a part of the body of the thermal shield.
Figure 4 depicts the power radiated by the assembly of silicon rods at a temperature of 1100°C which reaches the cold inner wall of the reactor at different times of the process.
Figure 5 shows the temperature of the silicon thermal shield at different times of the silicon production process by CVD.
Figure 6 shows the amount of silicon deposited on the shield according to its relative position with respect to the rods.

### Detailed Description of the Invention

The present invention consists of a thermal shield (1) suitable for use inside a reactor (2) for producing silicon by CVD. The thermal shield (1) surrounds the inner reaction space (2.1), where the silicon deposition by CVD occurs. When this reaction occurs on the surface of the silicon rods (3), it is necessary for operational temperatures to be between 900°C and 1200°C, which lead to an energy consumption to enable the reaction during the production process. There are energy losses, especially due to energy radiation and particularly infrared radiation, during the silicon production process which significantly reduce the efficiency of the production process for producing silicon with a high degree of purity.

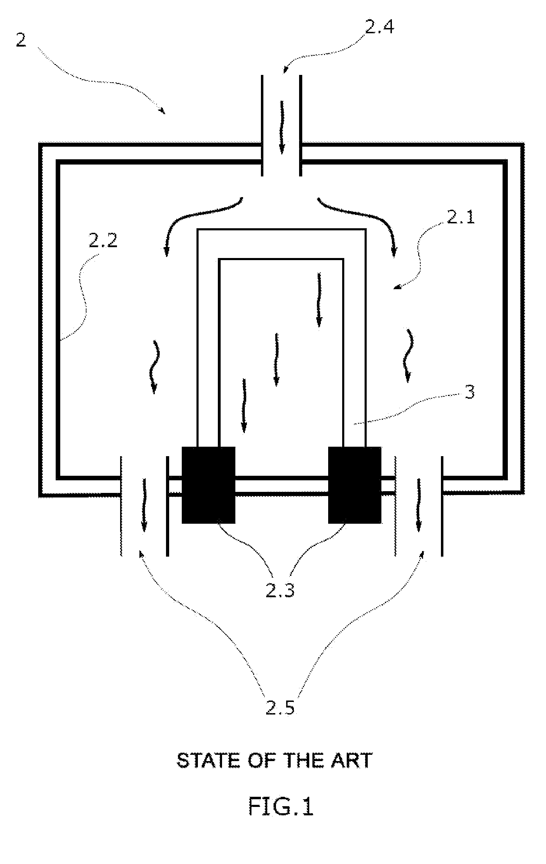

Figure 1 shows a schematic view of the reactor (2) for producing silicon by CVD. This reactor comprises a casing or vessel (2.2) of the reactor with an inner wall. Although it is possible to introduce an assembly of silicon rods (3), only one of these silicon rods (3) is depicted for the sake of clarity. When the walls of the reactor are made of metal, these walls are cooled to maintain a controlled environment, free of contaminants, inside the reactor (2) and particularly in the inner reaction space (2.1). In this example, the reactor has electric power supply means (2.3) which allow circulating a current through each of the silicon rods (3) in order to heat them. The reactor (2) has inlet means (2.4) for precursor gas supplying a flow of gas comprising the compounds necessary for the growth of the silicon rods (3). These inlet means, which are usually located at the base of the reactor (2), are depicted in the diagram of Figure 1 on the opposite side for the sake of clarity. Furthermore, it comprises a discharge (2.5) for residual gas to enable an outlet flow of gas comprising compounds in gaseous phase resulting from the chemical reaction.

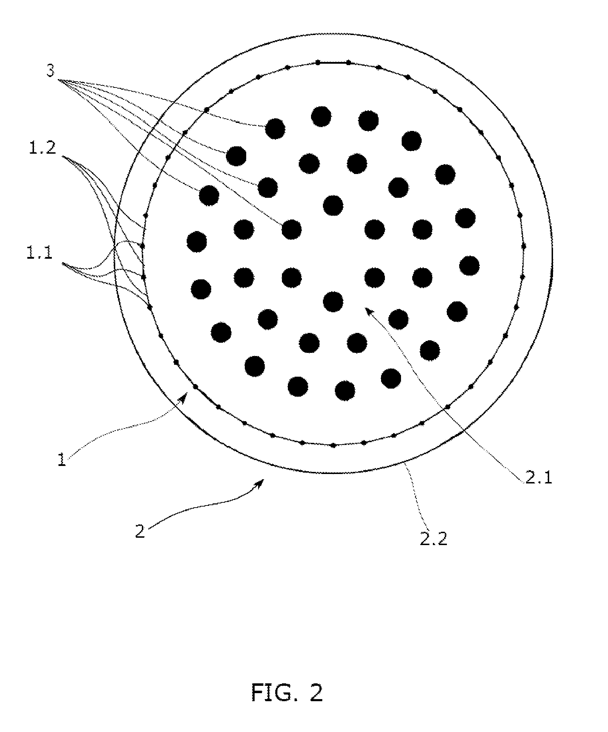

Figure 2 shows a cross-sectional view of a tank reactor (2), the diameter of the cold inner wall of the casing (2.2) of the reactor being 229 cm. In the reactor (2) there are 36 silicon rods (3) forming 3 concentric rings. The first ring has a diameter of 50 cm, the second ring has a diameter of 96 cm, the third ring has a diameter of 143 cm. The thermal shield (1) can be observed surrounding these silicon rods (3). In this embodiment, the body of the thermal shield (1) gives rise to a substantially cylindrical surface. The diameter of the thermal shield (1) is 199 cm and it surrounds the assembly of all the silicon rods (3). The surface area of the thermal shield (1) is 12.5 m². Thus, this thermal shield (1) can be arranged inside the reactor (2) between the inner reaction space (2.1) and the cold inner wall of the casing (2.2) of the reactor.

It is possible to consider other diameters of the thermal shield (1) to allow the radial position of the walls of the thermal shield (1) in the reactor (2), like the previous one, to give rise to the temperature thereof being between 700°C and 1000°C when the temperature of the silicon rods (3) is comprised between 900°C and 1200°C.

In this embodiment, the thermal shield (1) is manufactured entirely in silicon. Other embodiments of the present invention are characterized by using materials other than silicon and which are non-contaminating to form the supporting mesh.

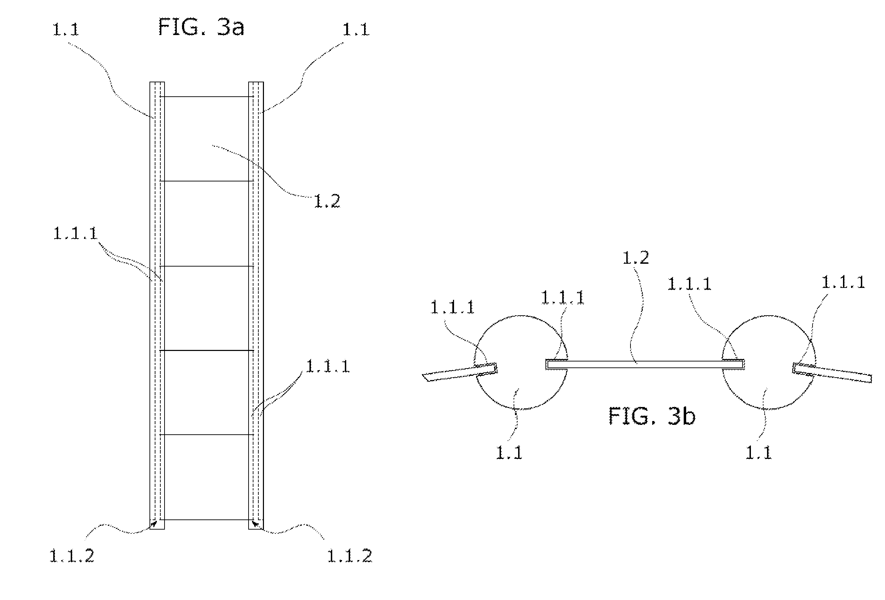

As observed in Figure 2 and in Figure 3, the structure giving rise to the thermal shield according to an embodiment of the invention is formed by an assembly of silicon bars (1.1). In this example, there are 39 bars (1.1) and the bars have a cylindrical shape with a diameter of 20 mm and a length of 2 m. The bars (1.1) are arranged according to a substantially straight prism the base of which is a polygon with 39 sides. The bars (1.1) are the edges of the prism. Between each of these edges there is a plurality of plates (1.2) giving rise to the side walls or faces of the prism connecting the bars (1.1) in twos. In this embodiment, the plates (1.2) are rectangular wafers.

In this embodiment, the material for the thermal shield (1) is conventionally obtained crystalline silicon, such as silicon rods (3) and wafers for solar cells or photovoltaic applications. This allows providing a thermal shield (1) from material obtained in a previous growth process, so it does not need a special manufacture and can be easily replaced.

Figure 3a shows two bars (1.1) in order to better show the structure of the thermal shield (1) in this embodiment. Each of said bars (1.1) is grooved and has two substantially similar grooves (1.1.1) which are machined by means of a milling process. These grooves (1.1.1) are indicated by a dotted line in Figure 3a and can be clearly observed in a cross-section of this structure in Figure 3b. Each of these grooves (1.1.1) has a width of about 0.3 mm. The grooves (1.1.1) allow introducing plates or wafers (1.2) in the structure and securing them. By making the size of the grooves (1.1.1) small enough, equal to or greater than the thickness of a wafer (1.2) but less than the thickness of two wafers (1.2), the coexistence of two wafers (1.2) in parallel at the same height of the structure is prevented, thus preventing the wafers (1.2) from being stacked due to the gravity at the bottom of the bars when the structure is in a vertical position.

As observed in Figure 3a, each of the grooves (1.1.1) in the bars (1.1) is prolonged to the upper part of each of the bars (1.1), thus allowing the introduction of wafers (1.2) in the structure until the complete assembly. However, it does not reach the lower end due to the presence of a support (1.1.2) of the plate at the lower end of each of the bars (1.1), indicated with an arrow in Figure 3a, which prevents the introduced wafers (1.2), giving rise to the side faces of the prism, from falling in the event of suspending the entire structure.

For the purpose of giving rigidity to the assembly, the wafers (1.2) and the bars (1.1) are welded. To that end, at least one point of the interface between each of the wafers (1.2) and the bars (1.1) is melted by means of a laser. When this point cools, each wafer (1.2) and each bar (1.1) will be attached. By repeating said operation at different points, the structure will gradually gain rigidity.

Shaping the entire thermal shield (1) consists of gradually adding new bars and wafers.

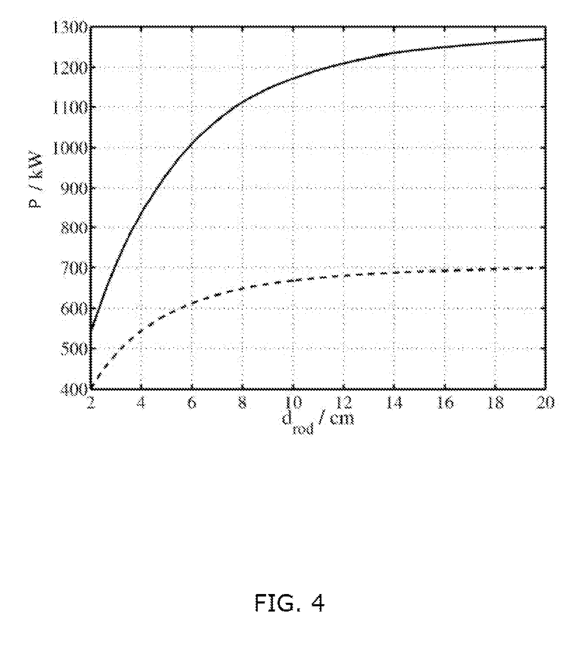

Figure 4 shows the power radiated by the assembly of silicon rods (3) P, at a temperature of 1100°C, which reaches the cold inner wall of the casing (2.2) of the reactor (2) shown in Figure 2 according to the diameter of silicon rod (3), *d_{rod}*, which corresponds to different times in the silicon production process by CVD. It shows both the power when there is no thermal shield (1) and considering the silicon thermal shield (1) (dotted line). It is observed that the power decreases considerably, between 70% to 30% with respect to the power consumed in the production process without a thermal shield (1), and therefore, in the same way, the energy consumed during the process is reduced to approximately 30% with respect to the case without a thermal shield (1). Thus, the ratio of the power invested per material produced is smaller upon increasing the diameter. The invention allows prolonging the production under these favorable conditions.

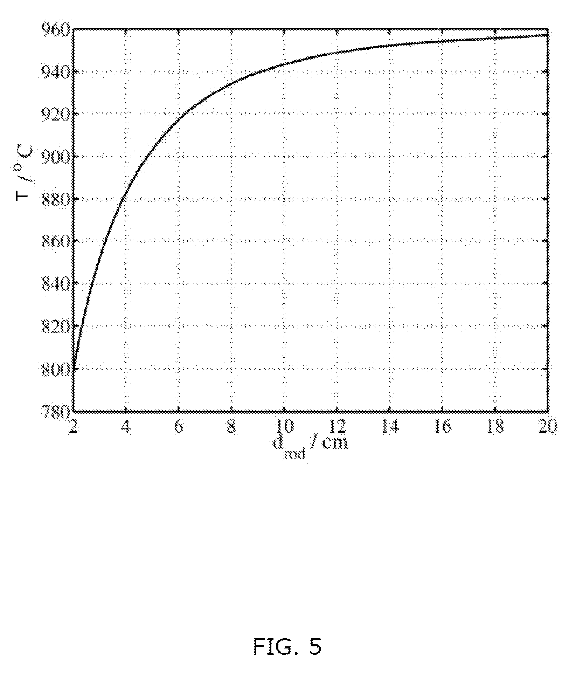

Figure 5 shows the temperature of the silicon thermal shield (1), T, according to the diameter of silicon rod (3), *d_{rod},* which corresponds to different times in the silicon production process by CVD. It can be seen how the temperature is between 810 and 960°C. Due to the high temperatures, a layer of about 5 mm will be deposited on the thermal shield (1). Three tons of silicon deposited on the silicon rods (3) and 134 kg deposited on the thermal shield (1) will be produced. Since in this example the thermal shield (1) is formed only by silicon with a great purity, both the silicon deposited on the silicon rods (3) and on the thermal shield (1) will be considered as silicon produced during the silicon production process by CVD.

In this embodiment, it is possible to see how the amount of silicon deposited on the thermal shield (1) depends on the temperature of the silicon rods (3) in a typical cycle of production by CVD. When the silicon rods (3) are at 900°C, the thermal shield (1) reaches 700°C and 80 kg of silicon are deposited. When the silicon rods (3) are at 1200°C, the thermal shield (1) reaches 1000°C and 150 kg of silicon are deposited. At a temperature of the silicon rods (3) of 1050°C, the thermal shield (1) reaches 850°C and 120 kg of silicon are deposited.

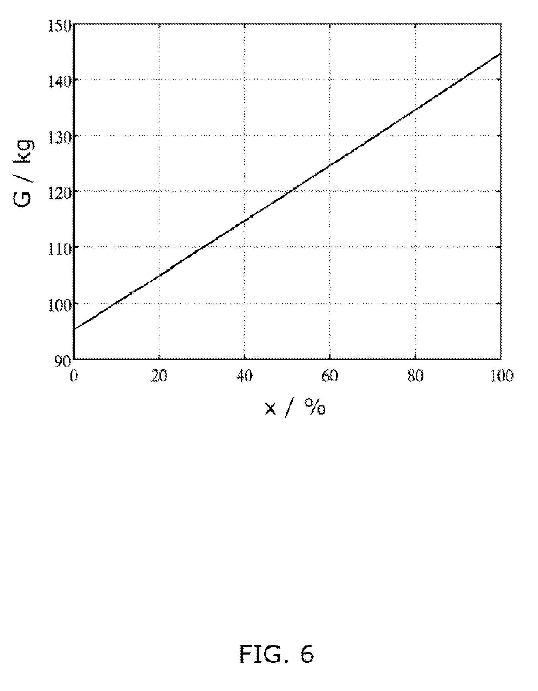

In this embodiment, considerable variations in the temperature of the thermal shield in the reactor are not observed. However, it is observed that the amount of silicon deposited on the thermal shield depends on the radial position of the thermal shield (1). Figure 6 shows how the amount of silicon deposited on the thermal shield (1), G, varies according to the relative distance x. This distance represents the distance between the thermal shield (1) and the silicon rods (3), i.e., the circumference with a smaller diameter in which the silicon rods (3) are inscribed. This distance is standardized by the distance between the cold inner wall of the casing (2.2) and said circumference in which the silicon rods (3) are inscribed. In other words, 100% means completely adhered to the cold inner wall of the casing (2.2) and 0% means that the thermal shield is adhered to the silicon rods (3). In other words, this amount can be increased by 50% when the shield is moved closer to the wall. Therefore, this position is an advantage as it increases the produced silicon production upon considering that the entire thermal shield is also silicon.

## Claims

1. A thermal shield (1) for silicon production reactors suitable for the arrangement inside a reactor (2) for producing silicon by chemical vapor deposition or CVD, wherein said shield is formed by a body having a surface partially or completely enveloping an inner reaction space (2.1), **characterized in that** at the working temperature in operational mode it is opaque to thermal radiation and non-contaminating.

2. The thermal shield (1) according to claim 1, **characterized in that** at least the surface of the body of the thermal shield (1) is covered by a silicon coating.

3. The thermal shield (1) according to claim 2, **characterized in that** the body giving rise to the enveloping surface is made of silicon.

4. The thermal shield (1) according to claim 3, **characterized in that** it comprises:
• a plurality of bars (1.1) arranged essentially parallel to one another and distributed according to a polygon according to a plane perpendicular to the axis of the bars; and,
• an assembly of plates (1.2),
such that the bars (1.1) are connected in twos by means of at least one plate (1.2.1).

5. The thermal shield (1) according to claim 4, **characterized in that** the plates (1.2) are essentially rectangular and the bars (1.1) are grooved such that the plates (1.1) are housed in said grooves (1.1.1).

6. The thermal shield (1) according to claim 5, **characterized in that** the grooves (1.1.1) of the bars (1.1) do not reach the lower part of the bar to give rise to a support (1.1.2) of the plate intended to be housed between said bars (1.1).

7. The thermal shield (1) according to claim 5 or 6, **characterized in that** between the bars (1.1) and the plates (1.2) there is at least one point of attachment, preferably by means of welding.

8. A reactor (2) for producing silicon by chemical vapor deposition or CVD comprising:
• a casing (2.2) of the reactor configured to give rise to an inner reaction space (2.1),
• electric power supply means (2.3) for supplying electric power to at least one rod (3) for producing silicon by CVD,
• inlet means (2.4) for precursor gas of the growth of the at least one silicon rod (3),
• discharge means (2.5) for residual gas,
• a protection shield against infrared radiation,
**characterized in that** the shield is a thermal shield (1) according to any of claims 1 to 7 and is located between the inner reaction space (2.1) and the casing (2.2) of the reactor.

9. A reactor (2) for producing silicon by chemical vapor deposition or CVD, **characterized in that** the thermal shield according to any of claims 3 to 7 is in a radial position in contact with inner walls of the casing (2.2) of the reactor.
